Europäisches Patentamt

European Patent Office

Office européen des brevets

(11) Publication number: **0 261 666 B1**

# EUROPEAN PATENT SPECIFICATION

(45) Date of publication of patent specification: **05.08.92**

(51) Int. Cl.⁵: **H01L 27/08,** H01L 29/04, H01L 21/82

(21) Application number: **87113917.6**

(22) Date of filing: **23.09.87**

(54) **Complementary type insulated gate field effect transistor.**

(30) Priority: **24.09.86 JP 223732/86**
**24.09.86 JP 223735/86**

(43) Date of publication of application:
**30.03.88 Bulletin 88/13**

(45) Publication of the grant of the patent:
**05.08.92 Bulletin 92/32**

(84) Designated Contracting States:
**DE FR GB**

(56) References cited:
**EP-A- 0 166 003**
**DE-A- 2 009 102**

**JAPANESE JOURNAL OF APPLIED PHYSICS,
vol. 8, no. 5, May 1969, pages 588-598, Tokyo,
JP; T. SATO et al.: "Effect of crystallographic
orientation on mobility, surface state density, and noise in p-type inversion layers on
oxidized silicon surfaces"**

(73) Proprietor: **NEC CORPORATION**
**7-1, Shiba 5-chome Minato-ku**
**Tokyo 108-01(JP)**

(72) Inventor: **Kasai, Naoki**
**c/o NEC Corporation 33-1, Shiba 5-chome**
**Minato-ku Tokyo(JP)**

(74) Representative: **Glawe, Delfs, Moll & Partner**
**Patentanwälte**
**Postfach 26 01 62 Liebherrstrasse 20**
**W-8000 München 26(DE)**

EP 0 261 666 B1

## Description

Background of the Invention:

The present invention relates to a complementary type insulated gate field effect transistor (hereinafter abbreviated as CMOS).

A CMOS has a low power consumption and high speed operation, and therefore various structures thereof have been proposed. In "DIGEST OF TECHNICAL PAPERS" of "1986 SYMPOSIUM ON VLSI TECHNOLOGY", pages 17 to 18, a new CMOS was disclosed by M. KINUGAWA et al. entitled "SUBMICRON 3D SURFACE - ORIENTATION - OPTIMIZED CMOS TECHNOLOGY" in which the P-channel transistor is formed on a (110) plane surface at a trench side wall provided inwardly from a (100) plane major surface of a silicon substrate, and the N-channel transistor is formed on the (100) plane major surface. The P-channel transistor has a good characteristic because (110) plane realizes a high hole mobility, and the N-channel transistor formed on (100) plane can keep a high reliability. However, the CMOS has a restriction to perform a high integrated density because the N-channel transistor is formed on the major surface of the substrate.

Summary of the Invention:

Accordingly, one object of the present invention is to provide an effective CMOS which realizes a high integrated density with the high hole mobility of the P-channel transistor and the high reliability such as reducing hot-electron effect of the N-channel transistor.

Another object of the invention is to provide an effective method of manufacturing the above-mentioned CMOS.

According to one feature of the present invention, there is provided a CMOS which comprises a silicon substrate having a major surface, a first side wall perpendicularly formed from the major surface inward into said substrate and having a surface of (110) plane, a second side wall perpendicularly formed from the major surface inward into the substrate and having a surface of (100) plane, a P-channel type insulated gate field effect transistor (IGFET) provided on the first side wall, and an N-channel type IGFET provided on the second side wall. When the major surface of the silicon is of (110) plane, the angle in the plane view between the first and second side walls is 90°. On the other hand, when the major surface of the silicon substrate is of (100) plane, the angle in the plan view between the first and second side walls is 45° or 135°. The first and second side walls may be positioned at a trench formed in the substrate, or at first and second trenches, respectively, formed in the substrate. Or else, the first and second side walls may be positioned at a protrusion formed in the substrate, or at first and second protrusions, respectively, formed in the substrate. In the process steps for manufacturing the CMOS, the directions in the plan view of the first and second side walls are defined by a direction of a orientation flat of a silicon wafer in which the CMOS is to be formed.

Brief Description of the Drawings:

Fig. 1 is a cross-sectional view showing a CMOS of a prior art;
Fig. 2A is a plan view showing a semiconductor wafer having the major surface of (110) plane in which side walls of the present invention are formed; and Fig. 2B is a plan view showing the relation of the surface states in side walls;
Fig. 3A is a perspective view schematically showing a trench at which first and second side walls are positioned, and Fig. 3B is a perspective view schematically showing first and second trenchs at which first and second side walls are respectively positioned;
Fig. 4A is a perspective view schematically showing a protrusion at which first and second side walls are positioned, and Fig. 4B is a perspective view schematically showing first and second protrusions at which first and second side walls are respectively positioned;
Figs. 5A to 5C are perspective views showing manufacturing process steps in sequence for forming a first embodiment;
Fig. 6 is a plan view showing the first embodiment of the present invention;
Figs. 7A and 7B are perspective views showing manufacturing process steps in sequence for forming a version of the first embodiment;
Fig. 8A is a plan view showing a semiconductor wafer having the major surface of (100) plane in which side walls of the present invention are formed, and Fig. 8B is a plan view showing the relation of the surface states in side walls;
Fig. 9A is a perspective view schematically showing a trench at which first and second side walls are positioned, and Fig. 9B is a perspective view schematically showing first and second trenchs at which first and second side walls are respectively positioned;
Fig. 10A is a perspective view schematically showing a protrusion at which first and second side walls are positioned, and Fig. 10B is a perspective view schematically showing first and second protrusions at which first and second side walls are respectively positioned;
Figs. 11A to 11C are perspective views showing manufacturing process steps in sequence for forming a second embodiment;

Fig. 12 is a plan view showing the second embodiment of the present invention; and

Figs. 13A and 13B are perspective view showing manufacturing process steps in sequence for forming a version of the second embodiment.

Description of the Prior Art:

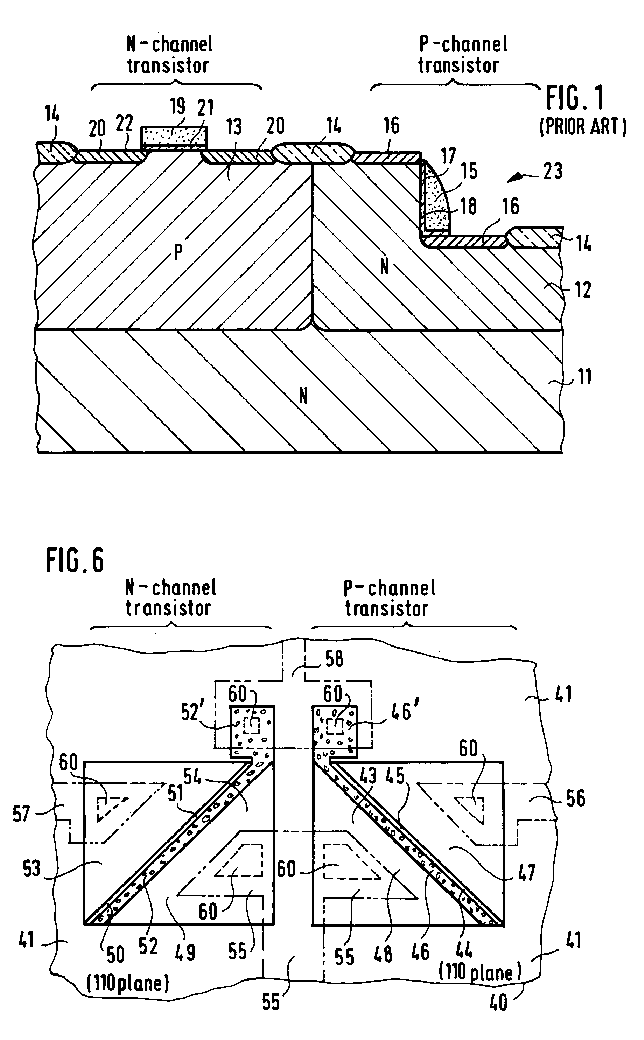

Referring to Fig. 1, a P-well 13 and an N-well 12 are formed in an N-type silicon substrate 11 having the major surface 22 of (100) plane. A trench 23 is formed in the N-well 12. The side wall surface 18 of the trench 23 is perpendicular to the major surface 22 and of (110) plane. On the side wall surface of (110) plane a silicon gate 15 of a P-channel transistor is formed via a gate insulating film 17, and P-type source and drain regions 16, 16 are formed between the gate insulating film 17 and a field insulating layer 14, respectively. On the other hand, a silicon gate 19 of an N-channel transistor is formed on the major surface 22 of (100) plane via a gate insulating film 21 and N-type source and drain regions 20, 20 are formed between the gate insulating film 21 and the field insulating layer 14, respectively.

Detailed Description of Embodiments:

(First embodiment)

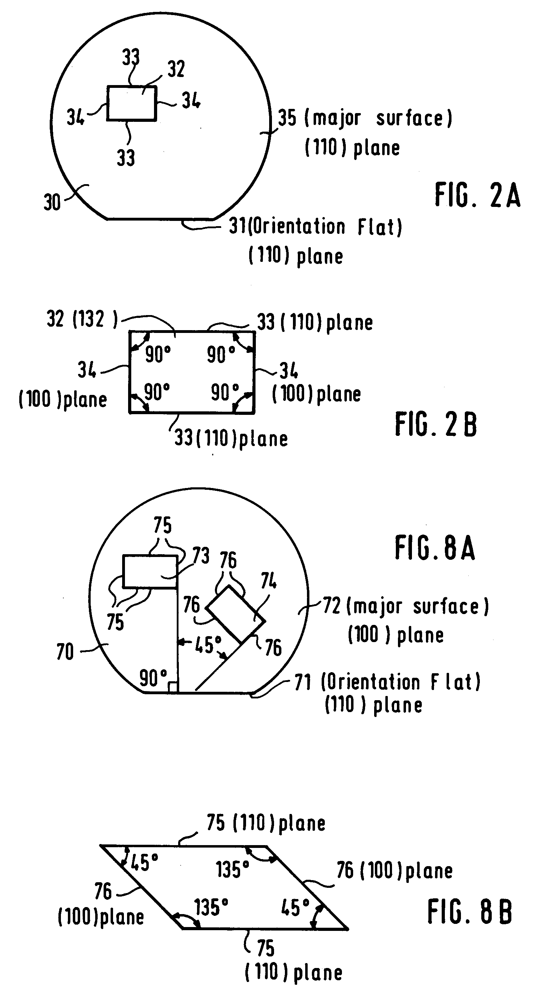

Referring to Figs. 2A and 2B, a silicon wafer 30 has the major surface 35 of (110) plane and an orientation flat 31. The surface of the orientation flat, that is, the side surface of the silicon wafer at the orientation flat is of (110) plane. When a trench 32 of rectangular or square shape in the plan view is formed from the major surface into the silicon substrate perpendicularly such that two first side walls 33, 33 are in parallel to the orientation flat 31 in the plan view and two second side walls 34, 34 are at right angle with the orientation flat 31 in the plan view, each of first side wall surfaces 33 becomes (110) plane and each of second side wall surfaces 34 becomes (100) plane.

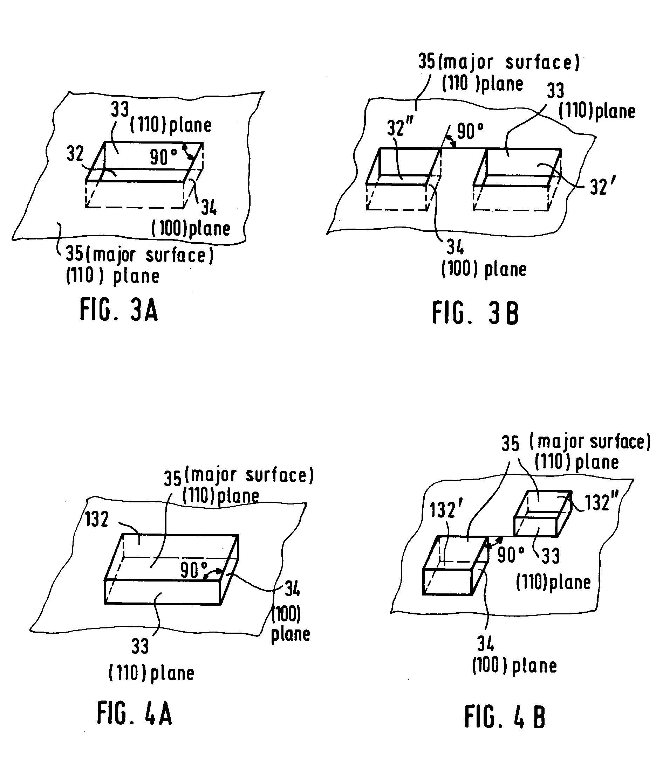

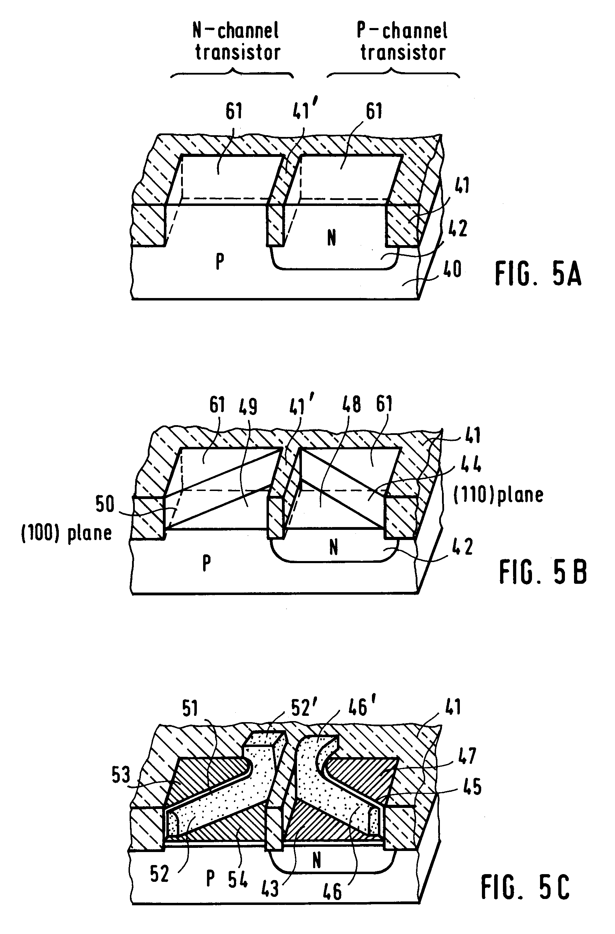

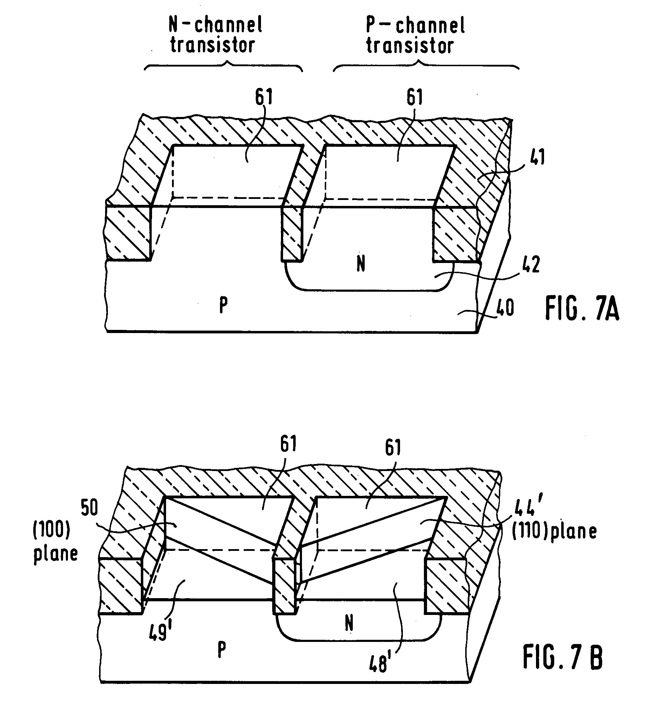

In the first embodiment, a P-channel IGFET is formed on a side wall as the first side wall 33 of (110) plane extending in parallel to the orientation flat in the plan view and formed perpendicularly from the major surface of the silicon substrate inward the substrate, and an N-channel IGFET is formed on a side wall as the second side wall 34 of (100) plane extending at right angle with the orientation flat in the plan view and formed perpendicularly from the major surface of the silicon substrate inward the substrate. The first and second side walls 33, 34 may be positioned at a single trench 32 as shown in Fig. 3A, or at different trenches 32' and 33", respectively, as shown in Fig. 3B. Further, the first and second side walls 33, 34 may be positioned at a single protrusion 132 as shown in Fig. 4A, or at different protrusions 132' and 132" as shown in Fig. 4B. In any cases, a P-channel IGFET formed on the first side wall 33 and an N-channel IGFET formed on the second side wall 34 constitute a CMOS. Referring to Figs. 5A to 5C and 6, a CMOS of the present invention of the first embodiment will be explained. A thick silicon oxide film as a field insulating layer 41 and an isolation layer 41' is selectively formed on a major surface 61 of (110) plane of a P-type silicon substrate 40, and an N-type well region 42 is formed from the major surface 61 inward the substrate (Fig. 5A). Next, as shown in Fig. 5B, trenches 48, 49 are formed by a reactive etching method from the major surface into the substrate by 1 $\mu$m depth so that the side wall surfaces 44, 50 become in perpendicular to the major surface 61. The N-type side wall surface 44 in the N-type well 42 is of (110) plane which corresponds to the first side wall 33 in Figs. 2 to 4, and the P-type side wall surface 50 in the P-type region of the substrate is of (100) plane which corresponds to the side wall 34 in Figs. 2 to 4. Therefore, the angle between the side wall 44 and the side wall 50 in the plan view (Fig. 6) is 90°. Next, as shown in Fig. 5C, a polysilicon gat electrode 46 is formed on the side wall 44 of (110) plane, which is used as the channel region of a P-type IGFET, via a gate insulating film 45, and a gate lead-out terminal 46' of polysilicon is continuously formed with the gate electrode 46 and provided on the field silicon oxide layer 41. Also, a polysilicon gate electrode 52 is formed on the side wall 50 of (100) plane, which is used as the channel region of an N-type IGFET, via a gate insulating film 51, and a gate lead-out terminal 52' of polysilicon is continuously formed with the gate electrode 52 and provided on the field insulating layer 41. Next, a mask material (not shown) such as photo-resist film is formed over the N-type transistor forming section (left side in Fig. 5C), and boron ions are implanted to form P-type source and drain regions 47, 43 of the P-channel IGFET and to introduce the boron ion into the silicon gate 46. After removing the mask material, another mask material (not shown) such as photo-resist film is newly formed over the P-type transistor forming section (right side in Fig. 5C), and arsenic ions are implanted to form N-type source and drain regions 53, 54 of the N-channel IGFET and to introduce the arsenic ion into the silicon gate 52. Next, a passivation film (not shown) such as silicon oxide film or silicon nitride film is entirely formed. Thereafter, as shown in Fig. 6, a $V_{DD}$ power supply line 56 of aluminum layer is connected to the P-type source region 47 of the P-channel IGFET through a contact hole 60 provided in the passivation film, and a Vss power supply line 57 of aluminum layer is connected to the N-type source 53 of the N-channel IGFET through a contact hole 60 provided in the passivation film. An output wiring layer 55 of aluminum layer is commonly connected to the P-type drain region 43 and the N-type drain region 54 through contact holes 60, 60 provided in the passivation film, and an input wiring layer 58 of aluminum layer is commonly connected to the P-type silicon gate 46 and the N-type silicon gate 52 at their terminals 46', 52', respectively, through contact holes 60, 60 provided in the passivation film. To avoid complexity, the aluminum wiring layers are represented by phantom lines in Fig. 6.

Figs. 7A and 7B correspond to the process steps shown in Figs. 5A and 5B, respectively, and in Figs. 7A, 7B, the same components as those in Figs. 5A, 5B are indicated by the same reference numerals. In the modification structure, the first side wall 44' of (110) plane, on which the P-channel transistor is formed, is provided by the trench 48', and the second side wall 50' of (100) plane, on which the N-channel transistor is formed, is provided by the trench 49'. The angle in the plan view between the side wall 44' and the side wall 50' is 90°. As shown in Fig. 7B, the directions of the side walls 44', 50' are different from these of side walls 44, 50 in Figs. 5B and 5C.

According to the first embodiment, the N-channel IGFET as well as P-channel IGFET is formed on the side wall. Consequently, the occupied area in the plan view of CMOS according to the present invention can be reduced by 20 to. 30% of that of prior art structure shown in Fig. 1, and therefore a high integrated density of IC can be expected.

(Second embodiment)

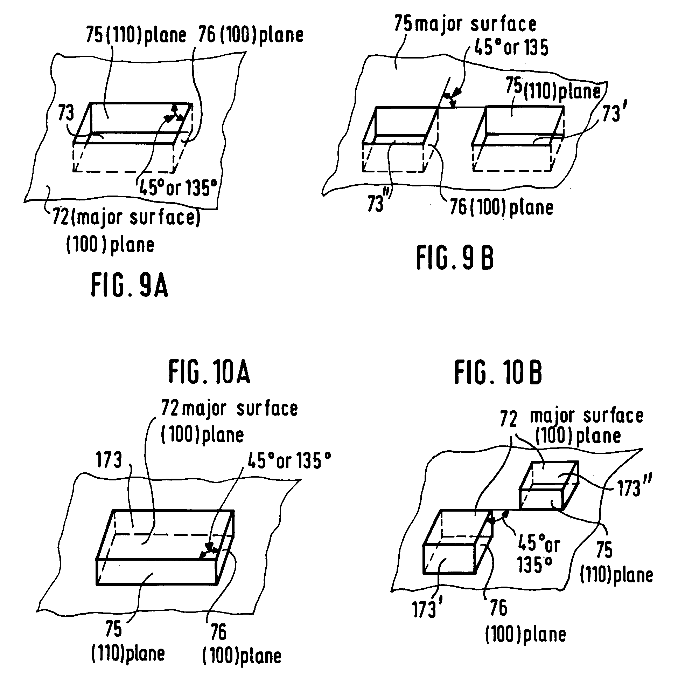

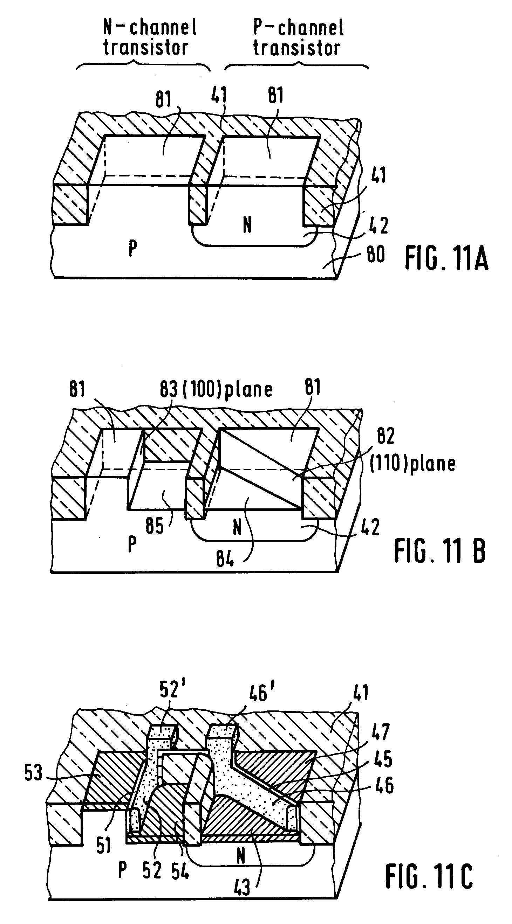

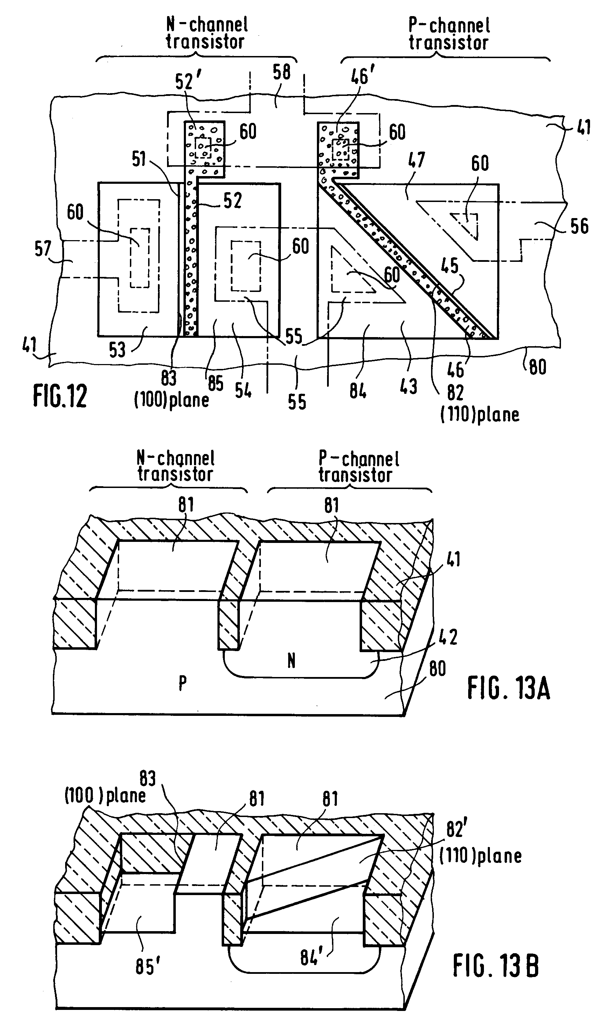

Referring to Figs. 8A and 8B, a silicon wafer 70 has the major surface of (100) plane and an orientation flat 71. The surface of the orientation flat, that is, the side surface of the silicon wafer at the orientation flat is of (110) plane. When a trench 73 of rectangular or square shape in the plan view is formed from the major surface 72 into the substrate such that two side walls 75, 75 are parallel to the orientation flat 71 in the plan view and the other two side walls 75, 75 are at right angle with the orientation flat 71 in the plan view, all side wall surfaces 75 become (110) plane. On the other hand, if a trench 74, which has the same plan shape as that of the trench 73 but inclines from the trench 73 by 45° in the plan view, the all side wall surfaces 76 become (100) plane. Therefore, as shown in Fig. 8B, the angle in the plan view between the side wall 75 of (110) plane and the side wall 76 of (100) plane is 45° or 135°. In the second embodiment, a P-channel IGFET is formed on a first side wall such as the side wall 75 of (110) plane extending in parallel to or at right angle with the orientation flat in the plan view and formed perpendicularly from the major surface inward the silicon substrate, and an N-channel IGFET is formed on a second side wall such as the side wall 76 of (100) plane inclined in the plan view from the first side wall by an angle of 45° or 135° and formed perpendicularly from the major surface of the substrate into the substrate. The first and second side walls 75 and 76 may be positioned in a single trench 73 as shown in Fig. 9A, or in different trenches 73' and 73", respectively, as shown in Fig. 9B. Further, the first and second side walls 75 and 76 may be positioned at a single protrusion 173 as shown in Fig. 10A, or at different protrusions 173' and 173" as shown in Fig. 10B. In any case, a P-channel type IGFET formed on the first side wall 75 and an N-channel type IGFET formed on the second side wall 76 constitute a CMOS of the present invention. Referring to Figs. 11A to 11C and Fig. 12, in which the same components as those in Figs. 5A to 5C and Fig. 6 are indicated by the same reference numerals. In Figs. 11A to 11C and Fig. 12, CMOS of the second embodiment of the present invention is provided on a silicon substrate 80 having the major surface 81 of (100) plane. Trenches 84, 85 are perpendicularly formed from the major surface 81 inward the silicon substrate 80. The P-channel transistor is formed on the first side wall 82 of (110) plane provided at the trench 84, and the N-channel transistor is formed on the second side wall 83 of (100) plane provided at the trench 85. The angle between the side wall 82 and the side wall 83 is 45° in the plan view (Fig. 12). After providing gate electrodes 46, 52, and source and drain regions 47, 43, 53 and 54 of respective IGFET's (Fig. 11C) as the same manner of the first embodiment, necessary wirings are formed to constitute a CMOS of the second embodiment as shown in Fig. 12.

Figs. 13A and 13B correspond to the process steps shown in Figs. 11A and 11B, respectively, and in Figs. 13A, 13B, the same components as those in Figs. 11A, 11B are indicated by the same reference numerals. In this embodiment, the first side wall 82' of (110) plane, on which the P-channel IGFET is formed, is provided by the trench 84', and the second side wall 83' of (100) plane, on which the N-channel IGFET is formed, is provided by the trench 85'. The angle in the plan view between the side wall 82' and the side wall 83' is 45°. As shown in Fig. 11B, the direction of the side first wall 82' is different from that of the first side wall 82 in Figs. 11B and 11C, and the second side wall 83' faces to the direction opposite to the side wall 83 in Figs. 11B and 11C.

## Claims

1. A complementary type insulated gate field effect transistor comprising a silicon substrate having a major surface, a first side wall perpendicularly formed from said major surface inward into said substrate and having a surface of (110) plane, a second side wall perpendicularly formed from said major surface inward into said substrate and having a surface of (100) plane, a P-channel type insulated gate field effect transistor provided on said first side wall, and an N-channel type insulated gate field effect transistor provided on said second side wall.

2. A complementary type transistor of Claim 1, in which said major surface is of (110) plane, and the angle in the plan view between said first and second side walls is 90°.

3. A complementary type transistor of Claim 1, in which said major surface is of (100) plane, and the angle in the plan view between said first and second side walls is 45° or 135°.

4. A complementary type transistor of Claim 1, in which said first and second side walls are positioned in a trench or trenches formed in said substrate.

5. A complementary type transistor of Claim 1, in which said first and second side walls are positioned on a protrusion or protrusions formed in said substrate.

6. A method of manufacturing a complementary type insulated gate field effect transistor comprising the steps of preparing a silicon wafer having a major surface of (110) plane and an orientation flat having a surface of (110) plane, forming a first side wall from said major surface perpendicularly extending inward into said substrate, said first side wall being parallel to said orientation flat in the plan view, forming a second side wall from said major surface perpendicularly extending inward into said substrate, said second side wall being at a right angle to said orientation flat in the plan view, forming a P-channel type insulated gate field effect transistor on said first side wall, and forming an N-channel type insulated gate field effect transistor on said second sidewall.

7. A method of manufacturing a complementary type insulated gate field effect transistor comprising the steps of preparing a silicon wafer having a major surface of (100) plane and an orientation flat having a surface of (110) plane, forming a first side wall from said major surface perpendicularly extending inward into said substrate, said first side wall being in parallel to or at a right angle to said orientation flat in the plan view, forming a second side wall from said major surface perpendicularly extending inward into said substrate, said second side wall being inclined in the plan view from said first side wall by 45° or 135°, forming a P-channel type insulated gate field effect transistor on said first side wall, and forming an N-channel type insulated gate field effect transistor on said second side wall.

## Revendications

1. Transistor à effet de champ à grille isolée du type complémentaire comprenant un substrat de silicium comportant une surface principale, une première paroi latérale formée perpendiculairement à partir de la surface principale dans le substrat et ayant une surface de plan (110), une seconde paroi latérale formée perpendiculaire à partir de la surface principale dans le substrat et ayant une surface de plan (100), un transistor à effet de champ à grille isolée du type à canal P prévu sur la première paroi latérale, et un transistor à effet de champ à grille isolée du type à canal N prévu sur la seconde paroi latérale.

2. Transistor du type complémentaire selon la revendication 1, dans lequel la surface principale est de plan (110) et l'angle dans la vue en plan entre les première et seconde parois latérales est de 90°.

3. Transistor du type complémentaire selon la revendication 1, dans lequel la surface principale est de plan (110) et l'angle dans la vue en plan entre les première et seconde parois latérales est de 45° ou de 135°.

4. Transistor du type complémentaire selon la revendication 1, dans lequel les première et seconde parois latérales sont positionnées dans une tranchée ou des tranchées formées dans le substrat.

5. Transistor du type complémentaire selon la revendication 1, dans lequel les première et seconde parois latérales sont positionnées sur une protubérance ou des protubérances formées dans le substrat.

6. Procédé pour fabriquer un transistor à effet de champ à grille isolée du type complémentaire comprenant les étapes consistant à : préparer une tranche de silicium ayant une surface principale de plan (100) et un méplat d'orientation ayant une surface de plan (110), former une première paroi latérale à partir de la surface principale s'étendant perpendiculairement dans le substrat, la première paroi latérale étant parallèle au méplat d'orientation dans la vue en plan, former une seconde paroi latérale à partir de la surface principale s'étendant perpendiculairement dans le substrat, la seconde paroi latérale étant à angle droit par rapport au méplat d'orientation dans la vue en plan, former un transistor à effet de champ à grille isolée de type à canal P sur la première paroi latérale et former un transistor à effet de champ à grille isolée à canal N sur la seconde paroi latérale.

7. Procédé pour fabriquer un transistor à effet de champ à grille isolée du type complémentaire comprenant les étapes consistant à : préparer une tranche de silicium ayant une surface principale de plan (100) et un méplat d'orientation ayant une surface de plan (110), former une première paroi latérale à partir de la surface principale s'étendant perpendiculairement dans le substrat, la première paroi latérale étant parallèle ou à angle droit par rapport au méplat d'orientation dans la vue en plan, former une seconde paroi latérale à partir de la surface principale s'étendant perpendiculairement dans le substrat, la seconde paroi latérale étant inclinée dans la vue en plan par rapport à la première paroi latérale de 45° ou de 135°, former un transistor à effet de champ à grille isolée du type à canal P sur la première paroi latérale et former un transistor à effet de champ à grille isolée du type à canal N sur la seconde paroi latérale.

**Patentansprüche**

1. Komplementär-Feldeffekttransistor mit isoliertem Gate mit einem Siliziumsubstrat, das eine Hauptfläche aufweist, einer ersten Seitenwandung, die senkrecht von der Hauptfläche nach innen in das Substrat ausgebildet ist und eine Oberfläche in der (110)-Ebene aufweist, einer zweiten Seitenwandung, die senkrecht von der Hauptfläche nach innen in das Substrat ausgebildet ist und eine Oberfläche in der (100)-Ebene aufweist, einem P-Kanal-Feldeffekttransistor mit isoliertem Gate, der auf der ersten Seitenwandung ausgebildet ist, und einem N-Kanal-Feldeffekttransistor mit isoliertem Gate, der auf der zweiten Seitenwandung ausgebildet ist.

2. Komplementärtransistor nach Anspruch 1, wobei die Hauptfläche in der (110)-Ebene liegt und in der Aufsicht der Winkel zwischen der ersten Seitenwandung und der zweiten Wandung 90° beträgt.

3. Komplementärtransistor nach Anspruch 1, wobei die Hauptfläche in der (100)-Ebene liegt und in der Draufsicht der Winkel zwischen der ersten Seitenwandung und der zweiten Seitenwandung 45° oder 135° beträgt.

4. Komplementärtransistor nach Anspruch 1, wobei die erste und die zweite Seitenwandung in einer Vertiefung oder in Vertiefungen, die in dem Substrat ausgebildet sind, angeordnet sind.

5. Komplementärtransistor nach Anspruch 1, wobei die erste Seitenwandung und die zweite Seitenwandung auf einem Vorsprung oder auf Vorsprüngen, die im Substrat ausgebildet sind, angeordnet sind.

6. Verfahren zur Herstellung eines Komplementär-Feldeffekttransistors mit isoliertem Gate mit den Schritten der Herstellung eines Silizium-Wavers mit einer Hauptfläche in der (110)-Ebene und einer Orientierungebene mit einer Fläche in der (110)-Ebene, Ausbilden einer ersten Seitenwandung von der Hauptfläche rechtwinkelig nach innen erstreckend in das Substrat, wobei die erste Seitenwandung parallel zur Orientierungsebene in der Aufsicht ist, Ausbilden einer zweiten Seitenwandung von der Hauptfläche senkrecht nach innen in das Substrat erstreckend, wobei die zweite Seitenwandung in der Aufsicht in einem rechten Winkel zu der Orientierungsebene steht, Ausbilden eines P-Kanal-Feldeffekttransistors mit isoliertem Gate auf der ersten Seitenwandung und Ausbilden eines N-Kanal-Feldeffekttransistors mit isoliertem Gate auf der zweiten Seitenwandung.

7. Verfahren zur Herstellung eines Komplementär-Feldeffekttransistors mit isoliertem Gate mit den Schritten der Herstellung eines Silizium-Wavers mit einer Hauptfläche in der (100)-Ebene und einer Orientierungsebene mit einer Oberfläche in der (110)-Ebene, Ausbildung einer ersten Seitenwandung von der Hauptfläche senkrecht nach innen in das Substrat erstreckend, wobei die erste Seitenwandung parallel oder in einem rechten Winkel zu der Orientierungsebene in der Draufsicht steht, Ausbildung einer zweiten Seitenwandung von der Hauptfläche senkrecht nach innen in das Substrat erstreckend, wobei die zweite Seitenwandung in der Aufsicht gegen die erste Seitenwandung um 45° geneigt ist, Ausbildung eines P-Feldeffekttransistors mit isoliertem Gate auf der ersten Seitenwandung und Ausbildung eines N-Kanal-Feldeffekttransistors mit isoliertem Gate auf der zweiten Seitenwandung.

FIG. 1
(PRIOR ART)

FIG.6

33
32
34
34
35 (major surface)
(110) plane
33
30
31 (Orientation Flat)
(110) plane

**FIG. 2A**

32 (132)
33 (110) plane
90° 90°
34
34
(100) plane
90° 90°
(100) plane
33 (110) plane

**FIG. 2 B**

75
73 76
76
74
**FIG. 8A**
75
76
72 (major surface)
(100) plane
70
45°
76
90°
71 (Orientation Flat)
(110) plane

75 (110) plane
45°
135°
76 (100) plane
76
135°
45°
(100) plane
**FIG. 8 B**
75
(110) plane

33 (110) plane

32

90°

34

(100) plane

35 (major surface)
(110) plane

**FIG. 3A**

35 (major surface)
(110) plane

32″

90°

33
(110) plane

34
(100) plane

32′

**FIG. 3B**

35 (major surface)
(110) plane

132

90°

34
(100)
plane

33
(110) plane

**FIG. 4A**

35 (major surface)
(110) plane

132′

132″

90°

33
(110) plane

34
(100) plane

**FIG. 4B**

FIG. 5A

FIG. 5B

FIG. 5C

EP 0 261 666 B1

FIG. 7A

FIG. 7 B

75(110)plane  76(100)plane

73

45°or 135°

72(major surface)
(100)plane

**FIG. 9A**

75 major surface
45°or 135

75(110)plane

73'

73"

76(100)plane

**FIG. 9 B**

**FIG. 10A**

72 major surface
(100)plane

173

45°or 135°

75
(110)plane

76
(100)plane

**FIG. 10 B**

72  major surface
(100)plane

173"

173'

45°or
135°

76
(100)plane

75
(110)plane

N-channel
transistor

P-channel
transistor

81   41   81

41

42

80   **FIG. 11A**

P   N

81   83 (100) plane   81

82
(110) plane

42

85   N

P   84   **FIG. 11 B**

52'   46'   41

47

45

53   46

51

P   52   54   N

43   **FIG. 11C**

FIG.12

FIG. 13A

FIG. 13 B